# EUROPEAN PATENT APPLICATION

(11) **EP 4 708 452 A1**
(43) Date of publication of application: **11.03.2026**
(21) Application number: 25201422.0
(22) Date of filing: 10.09.2025
(51) Int. Cl.: H01M 10/48, H02J 7/47, H02J 7/80, G01R 31/385

(54) **BATTERY CELL REPLACEMENT DETECTION APPARATUS AND METHOD**

(30) Priority: 10.09.2024 KR 20240122825
(71) Applicant: SAMSUNG SDI CO., LTD., Yongin-si, Gyeonggi-do 17084 (KR)
(72) Inventor: KANG, Kyung Do, 16678 Suwon-si (KR); CHO, Young Shin, 16678 Suwon-si (KR); PARK, Jong Sam, 16678 Suwon-si (KR)
(74) Representative: Marks & Clerk LLP

(57) **Abstract**

The present disclosure relates to a battery cell replacement detection apparatus and method, and is directed to presenting a mechanism that permanently prevents a battery pack from being used by determining, through cell data retained by a battery management system (BMS) after the battery pack wakes up, that a battery cell has been replaced. To this end, the present disclosure provides a configuration that obtains the cell data related to charging of the battery from the BMS, and determines whether the battery cell has been replaced by comparing the cell data with data stored in a memory.

## Description

### BACKGROUND

### 1. Field

Aspects of the present disclosure relate to an apparatus and method for detecting whether a battery cell has been replaced in a battery pack.

### 2. Discussion of Related Art

Unlike a primary battery that cannot be recharged, a secondary battery is a battery that can be recharged and discharged. A low-capacity secondary battery may be used for portable small-sized electronic devices, such as smartphones, feature phones, notebook computers, digital cameras, and camcorders, and a high-capacity secondary battery is widely used as a power source for driving a motor and a power storage battery in hybrid vehicles or electric vehicles. The secondary battery includes an electrode assembly including a positive electrode and a negative electrode, a case accommodating the electrode assembly, an electrode terminal connected to the electrode assembly, and the like.

The above information disclosed in this Background section is for enhancement of understanding of the background of the present disclosure, and therefore, it may contain information that does not constitute related (or prior) art.

### SUMMARY

Users of products such as vacuum cleaners, mobile phones, or laptops frequently purchase non-genuine batteries (so-called fake batteries) and install the non-genuine batteries in their products because the price is low.

However, non-genuine batteries (which may also be referred to as unauthorized or unverified batteries) often do not include stabilization circuits or include only partial stabilization circuits needed to reliably operate various circuits that constitute the battery pack. This results in a risk of overheating and explosion, and may also lead to unstable power supply to a product, thereby causing product malfunction.

To prevent the use of such non-genuine batteries and promote the use of genuine batteries, an authentication function for genuine products via communication has been introduced. However, in order to pass the authentication function, there are increasing cases in which third-party companies sell a battery pack with a printed circuit board (PCB) of a battery management system (BMS) intact while replacing only a battery cell, and when the battery cell is replaced while the battery pack is in a shutdown state and then wakes up, the BMS applied to the battery pack cannot detect whether the battery cell has been replaced. As a result, the risks of explosion due to overheating of the battery pack and the issues of product malfunction due to unstable power supply are still present.

Aspects of the present disclosure have been devised to address the above-described issues, and aspects of the present disclosure are directed to providing a battery cell replacement detection apparatus and method, capable of detecting whether a battery cell has been replaced in a battery pack and determining whether the use of the battery pack should be prohibited based on the detection result, to prevent non-genuine batteries from being installed in the battery pack.

However, objects that the present disclosure intends to achieve are not limited to the above-described objects and other objects that are not described may be clearly understood by those skilled in the art from the following description.

According to some embodiments of the present disclosure, there is provided a battery cell replacement detection apparatus including, a memory, and a processor configured to obtain cell data related to charging of a battery from a battery management system (BMS), compare the cell data with data stored in the memory, and determine whether a battery cell has been replaced.

According to some embodiments of the present disclosure, there is provided a battery cell replacement detection apparatus including: a memory; and a processor configured to obtain cell data related to charging of a battery from a battery management system (BMS), to compare the cell data with data stored in the memory, and to determine whether a battery cell has been replaced.

In some embodiments, the processor is configured to enter a permanent fault mode to permanently prevent the battery from being used in response to determining that the battery cell has been replaced.

In some embodiments, the processor is configured to calculate an expected charging capacity for fully charging the battery after wake-up.

In some embodiments, the processor is configured to determine whether the battery cell has been replaced by comparing an actual charging amount from wake-up to full charge of the battery with the expected charging capacity.

In some embodiments, the processor is configured to calculate the expected charging capacity based on a current state of charge (SOC) value after the battery wakes up and a battery capacity stored in the memory.

In some embodiments, the processor is configured to determine that the battery cell has been replaced in response to a difference between the actual charging amount and the expected charging capacity exceeding a preset threshold value.

In some embodiments, the processor is configured to determine whether the battery cell has been replaced by detecting an overflow in an SOC value during the charging of the battery.

In some embodiments, the processor is configured to determine that the battery cell has been replaced in response to the SOC value of the battery from wake-up to first full charge of the battery exceeding a threshold value stored in the memory.

In some embodiments, the processor is configured to determine whether the battery cell has been replaced by comparing an open circuit voltage (OCV) value of the battery at a full charge SOC value with an OCV value stored in the memory.

In some embodiments, the processor is configured to stop the charging at a point that is a set range of the full charge SOC value of the battery, to measure the OCV value of the battery, and to compare the measured OCV value with the OCV value stored in the memory.

In some embodiments, the processor is configured to determine that the battery cell has been replaced in response to a difference between the measured OCV value and the OCV value stored in the memory exceeding a preset threshold value.

According to some embodiments of the present disclosure, there is provided a battery cell replacement detection method including: obtaining, by a processor, cell data related to charging of a battery from a battery management system (BMS); and determining, by the processor, whether a battery cell has been replaced by comparing the cell data with data stored in a memory.

In some embodiments, the battery cell replacement detection method further includes: causing the processor to enter a permanent fault mode to permanently prevent the battery from being used in response to determining that the battery cell has been replaced.

In some embodiments, the determining of whether the battery cell has been replaced includes calculating an expected charging capacity for fully charging the battery after wake-up.

In some embodiments, the determining of whether the battery cell has been replaced further includes: comparing an actual charging amount from wake-up to full charge of the battery with the expected charging capacity to determine whether the battery cell has been replaced.

In some embodiments, the determining of whether the battery cell has been replaced includes: detecting an overflow in a state of charge (SOC) value during the charging of the battery to determine whether the battery cell has been replaced.

In some embodiments, the determining of whether the battery cell has been replaced includes: determining that the battery cell has been replaced in response to the SOC value of the battery from wake-up to first full charge of the battery exceeding a threshold value stored in the memory.

In some embodiments, the determining of whether the battery cell has been replaced includes: comparing an open circuit voltage (OCV) value of the battery at a full charge SOC value with an OCV value stored in the memory to determine whether the battery cell has been replaced.

In some embodiments, the determining of whether the battery cell has been replaced includes: measuring the OCV value of the battery after stopping the charging at a point that is a set range of a full charge SOC value; comparing the measured OCV with the OCV value stored in the memory; and determining whether the battery cell has been replaced based on a result of the comparing.

In some embodiments, the determining of whether the battery cell has been replaced includes: determining that the battery cell has been replaced in response to a difference between the measured OCV value and the OCV value stored in the memory exceeding a preset threshold value. At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:
FIG. 1 illustrates a prismatic battery according to some embodiments of the present disclosure;
FIG. 2 illustrates a cross-sectional view of the prismatic battery according to some embodiments of the present disclosure;
FIG. 3 illustrates a battery module according to some embodiments of the present disclosure;
FIGS. 4A and 4B illustrate a battery pack according to some embodiments of the present disclosure;
FIG. 5 illustrates a block diagram of a battery cell replacement detection apparatus according to some embodiments of the present disclosure;
FIG. 6 illustrates an example for describing a process of detecting an excess in an expected charging capacity in the battery cell replacement detection apparatus according to some embodiments of the present disclosure;
FIG. 7 illustrates an example graph for describing a process of detecting a state of charge (SOC) overflow during charging in the battery cell replacement detection apparatus according to some embodiments of the present disclosure;
FIG. 8 illustrates an example graph for describing a process of comparing open circuit voltage (OCV) values at a full charge SOC in the battery cell replacement detection apparatus according to some embodiments of the present disclosure; and
FIGS. 9 and 10 illustrate flowcharts of a battery cell replacement detection method according to some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Before providing a detailed description of some embodiments of the present disclosure , an overview of a structure of a battery, which is the object of battery cell replacement detection according to some embodiments, will be described.

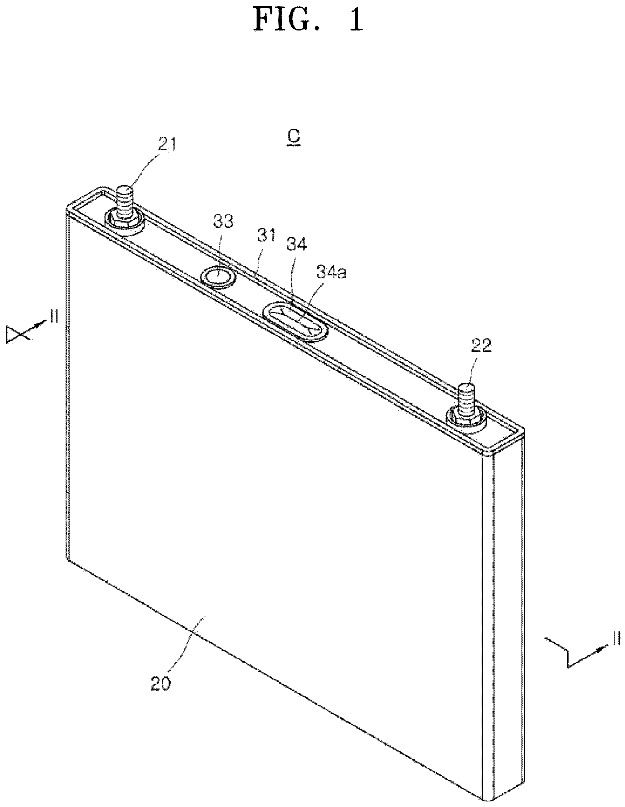

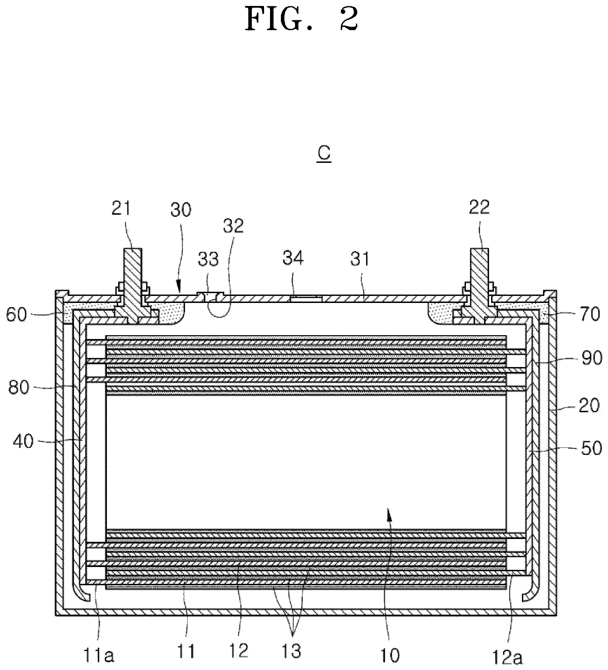

FIG. 1 is a perspective view illustrating a secondary battery according to some embodiments of the present disclosure, and FIG. 2 is a cross-sectional view taken along the line II-II in FIG. 1. (While FIGS. 1 and 2 may show some of the same reference numerals as the other drawings, it should be noted that the reference numerals shown in FIGS. 1 and 2 may be used solely in reference to FIGS. 1 and 2.)

Referring to FIGS. 1 and 2, the secondary battery (a plurality of battery cells) C according to some embodiments of the present disclosure may include at least one electrode assembly 10 wound with a separator 13 as an insulator between the positive electrode 11 and the negative electrode 12, a case 20 in which the electrode assembly 10 is received (or accommodated) therein, and a cap assembly 30 coupled to an opening of the case 20.

The secondary battery C according to some embodiments illustrated in FIGS. 1 and 2 will now be described as an example of a prismatic lithium ion secondary battery. However, the present disclosure is not limited thereto, and suitable aspects, features and principles described herein may be applied to various other types of batteries, such as lithium polymer batteries and/or cylindrical batteries.

Each of the positive electrode 11 and the negative electrode 12 may include a current collector made of a thin metal foil having a coated portion on which an active material is coated and an uncoated portion 11a, 12a on which an active material is not coated.

The positive electrode 11 and the negative electrode 12 are wound after interposing the separator 13, which is an insulator, therebetween. However, the present disclosure is not limited thereto, and the electrode assembly 10 may have a structure in which a positive electrode 11 and a negative electrode 12, each made of a plurality of sheets, are alternately stacked with a separator interposed therebetween.

The case 20 may form the overall outer appearance of the secondary battery C and may be made of a conductive metal, such as aluminum, aluminum alloy, or nickel-plated steel. In addition, the case 20 may provide a space in which the electrode assembly 10 is accommodated.

The cap assembly 30 may include a cap plate 31 covering an opening in the case 20, and the case 20 and the cap plate 31 may be made of a conductive material. The positive and negative electrode terminals 21 and 22 electrically connected to the positive electrode 11 and the negative electrode 12, respectively, may be installed to penetrate (or extend through) the cap plate 31 and protrude outwardly therethrough.

In addition, outer peripheral surfaces (e.g., circumferential surfaces) of upper pillars of the positive and negative electrode terminals 21 and 22 protruding outwardly from the cap plate 31 may be threaded and may be fixed to the cap plate 31 by utilizing nuts.

However, the present disclosure is not limited thereto, and the positive and negative electrode terminals 21 and 22 may have a rivet structure and may be riveted or welded to the cap plate 31.

In addition, the cap plate 31 may be made of a thin plate and may be coupled to the opening in the case 20, and an electrolyte injection port 32 into which a sealing stopper 33 may be installed may be located (e.g., formed) in the cap plate 31, and a vent portion 34 having a notch 34a may be installed.

The positive and negative electrode terminals 21 and 22 may be electrically connected to current collectors including first and second current collectors 40 and 50 (hereinafter referred to as positive and negative current collectors) by being bonded or coupled (e.g., by welding) to the positive uncoated portion 11a and the negative electrode uncoated portion 12a, respectively.

For example, the positive and negative electrode terminals 21 and 22 may be coupled by welding to the positive and negative electrode current collectors 40 and 50, respectively. However, the present disclosure is not limited thereto, and the positive and negative electrode terminals 21 and 22 and the positive and negative electrode current collectors 40 and 50 may be integrally formed in some embodiments.

In addition, an insulation member may be installed between the electrode assembly 10 and the cap plate 31. The insulation member may include first and second lower insulation members 60 and 70, and each of the first and second lower insulation members 60 and 70 may also have a portion located between the electrode assembly 10 and the case 20.

In addition, according to some embodiments of the present disclosure, one end of a separation member may face one side of the electrode assembly 10 and may be installed between the insulation member and the positive or negative electrode terminals 21 and 22.

In some embodiments, the separation member may include first and second separation members 80 and 90.

In such embodiments, first ends of the first and second separation members 80 and 90 installed to face one side of the electrode assembly 10 may be respectively installed between the first and second lower insulation members 60 and 70 and the positive and negative electrode terminals 21 and 22.

Accordingly, the positive and negative electrode terminals 21 and 22, which may be coupled by welding to the positive and negative electrode current collectors 40 and 50, may be coupled to first ends of the first and second lower insulation members 60 and 70 and the first and second separation members 80 and 90.

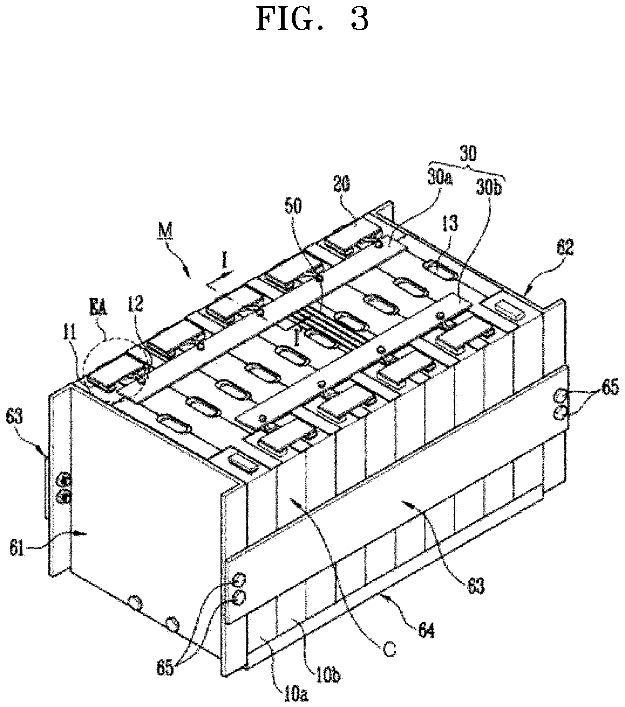

FIG. 3 is a perspective view illustrating the battery module M according to some embodiments of the present disclosure. (While FIG.3 may show some of the same reference numerals as the other drawings, it should be noted that the reference numerals shown in FIG. 3 may be used solely in reference to FIG. 3.)

Referring to FIG. 3, the battery module M, according to some embodiments of the present disclosure, includes a plurality of battery cells C that include terminal portions 11 and 12 and are arranged in one direction, a connection tab 20 that connects a battery cell 10a and an adjacent battery cell 10b, and a protection circuit module 30 of which one end portion is connected to the connection tab 20. The protection circuit module 30 may be a battery management system (BMS). In addition, the connection tab 20 includes a body portion in contact with the terminal portions 11 and 12 between adjacent battery cells 10a and 10b, and an extension portion that extends from the body portion 22 and is connected to the protection circuit module 30. The connection tab 20 may be a busbar.

The battery cell C may include a battery case, and an electrode assembly and an electrolyte accommodated in the battery case. The electrode assembly and the electrolyte electrochemically react with each other to generate energy. The terminal portions 11 and 12 electrically connected to the connection tab 20 and a vent 13, which is a discharge passage for gas generated inside of the battery cell C, may be provided at one side of the battery cell C. The terminal portions 11 and 12 of the battery cell 10 may be a positive electrode terminal 11 and a negative electrode terminal 12 having different polarities. The terminal portions 11 and 12 of adjacent battery cells 10a and 10b may be electrically connected in series or parallel by the connection tab 20 to be described below. Although an example of serial connection has been described above, the present disclosure is not limited to such a structure, and of course, various connection structures can be adopted as needed. In addition, the number and arrangement of the battery cells C are not limited to the structure shown in FIG. 3 and may be changed as needed.

The plurality of battery cells C may be arranged in one direction such that wide surfaces of the battery cells C face each other, and the plurality of arranged battery cells C may be fixed by housings 61, 62, 63, and 64. The housings 61, 62, 63, and 64 may include a pair of end plates 61 and 62 facing the wide surfaces of the battery cells 10, and side plates 63 and a bottom plate 64, which connect the pair of end plates 61 and 62. The side plate 63 may support a side surface of the battery cell 10, and the bottom plate 64 may support a bottom surface of the battery cell 10. In addition, the pair of end plates 61 and 62, the side plate 63, and the bottom plate 64 may be connected (e.g., affixed) by members such as bolts 65 or the like.

The protection circuit module 30 may include (e.g., be mounted with) electronic components and protection circuits and may be electrically connected to the connection tab 20 to be described below. The protection circuit module 30 may include a first protection circuit module 30a and a second protection circuit module 30b that extend at different positions in a direction in which the plurality of battery cells C are arranged. In such examples, the first protection circuit module 30a and the second protection circuit module 30b may be spaced a certain interval apart from each other, may be positioned parallel to each other, and may each be electrically connected to the connection tab 20 adjacent thereto. For example, the first protection circuit module 30a may be formed to extend at one upper side of the plurality of battery cells C in the direction in which the plurality of battery cells C are arranged, and the second protection circuit module 30b may be formed to extend at the other upper side of the plurality of battery cells C in the direction in which the plurality of battery cells C are arranged. The second protection circuit module 30b may be positioned to be spaced a certain distance (e.g., interval) apart from the first protection circuit module 30a with the vent 13 interposed therebetween and may be disposed parallel to the first protection circuit module 30a. In this way, two protection circuit modules are disposed in parallel and spaced apart from each other in the direction in which the plurality of battery cells C are arranged, thereby substantially reducing (e.g., minimizing) an area of a printed circuit board (PCB) constituting the protection circuit module. That is, the protection circuit module is provided as two separate protection circuit modules, thereby substantially reducing (e.g., minimizing) an unnecessary PCB area. The first protection circuit module 30a and the second protection circuit module 30b may be connected to each other by a conductive connection member 50. In such examples, one side of the connection member 50 may be connected to the first protection circuit module 30a, and the other side thereof may be connected to the second protection circuit module 30b so that an electrical connection may be made between the two protection circuit modules.

The connection may be performed through any method, for example, soldering, resistance welding, laser welding, and projection welding methods.

The connection member 50 may be, for example, an electric wire. In addition, the connection member 50 may be made of an elastic or flexible material. Through the connection member 50, it is possible to check and manage whether the voltage, temperature, and current of the plurality of battery cells C are normal. That is, information about a voltage, a current, a temperature, or the like received by the first protection circuit module from the connection tabs adjacent thereto and information about a voltage, a current, a temperature, or the like received by the second protection circuit module from the connection tabs adjacent thereto may be integrally managed through the connection member 50 by the protection circuit module 30.

In addition, when the battery cell C swells, any impact may be absorbed due to the elasticity or flexibility of the connection member 50, thereby preventing damage to the first and second protection circuit modules 30a and 30b.

In addition, the shape and structure of the connection member 50 are not limited to the shape shown in FIG. 3, and any suitable shape or structure may be used.

In this way, the protection circuit module 30 is provided as the first and second protection circuit modules 30a and 30b, the area of the PCB constituting the protection circuit module can be substantially reduced (e.g., minimized), thereby securing a space inside the battery module M. Thus, a fastening operation of connecting the connection tab 20 and the protection circuit module 30 may be facilitated, and also a repair may be facilitated when an abnormality is detected in the battery module M, thereby improving operation efficiency.

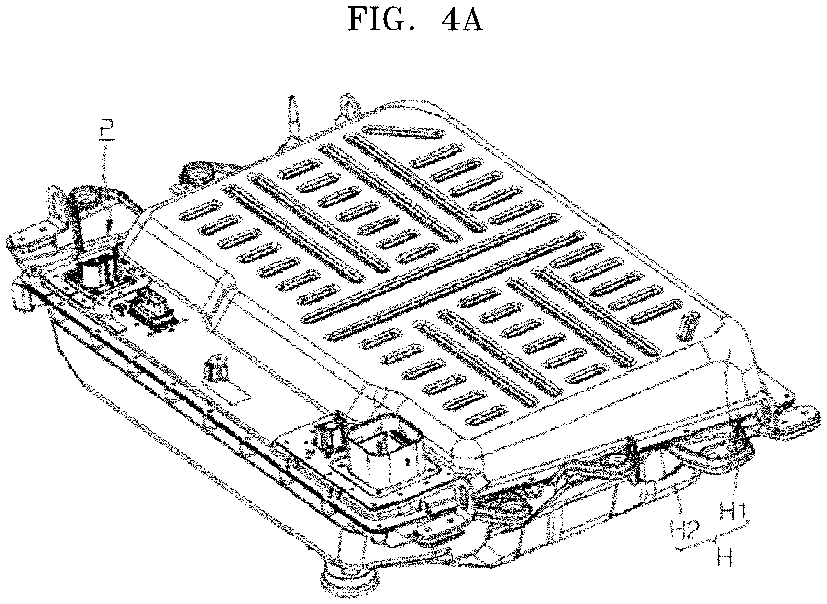

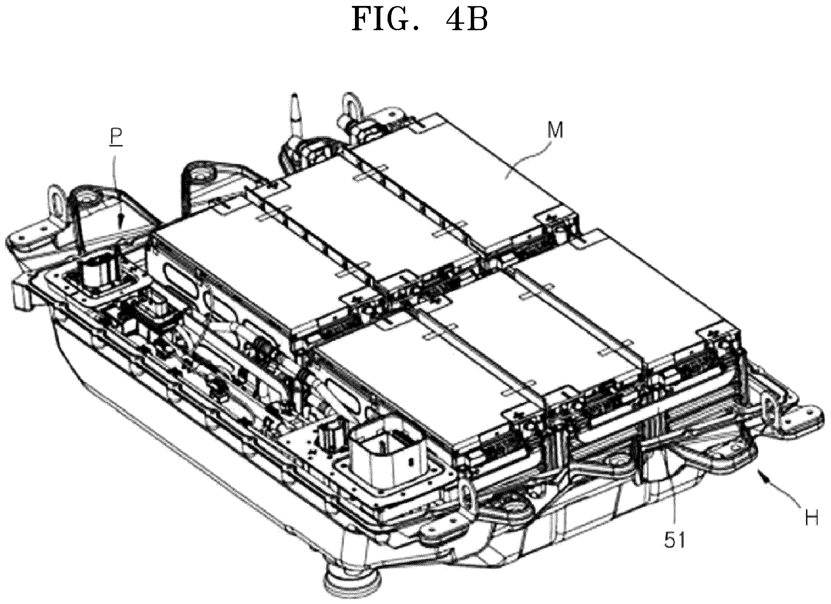

FIGS. 4A and 4B illustrate the battery pack P according to some embodiments of the present disclosure. (While FIGS. 4A and 4B may show some of the same reference numerals as the other drawings, it should be noted that the reference numerals shown in FIGS. 4A and 4B may be used solely in reference to FIGS. 4A and 4B.)

The battery pack P may include a plurality of battery modules M and a housing H for accommodating the plurality of battery modules M. For example, the housing H may include first and second housings H1 and H2 that are coupled to face each other with the plurality of battery modules M interposed therebetween. The plurality of battery modules M may be electrically connected to each other using a busbar 51, and the plurality of battery modules M may be electrically connected to each other in series, in parallel, or in a series-parallel combination scheme to obtain the desired electrical output power.

Based on the battery structure described above, a method of detecting the replacement of a battery cell according to some embodiments will be described in detail below.

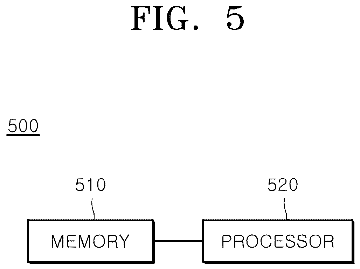

FIG. 5 is a block diagram of a battery cell replacement detection apparatus according to some embodiments of the present disclosure.

Referring to FIG. 5, a battery cell replacement detection apparatus 500 according to some embodiments may include a memory 510 and a processor 520, each of which may be configured with a battery, which is the object of cell replacement detection according to some embodiments, to form a battery pack.

At least one command executed by the processor 520 to be described later may be stored in the memory 510. The memory 510 may be implemented as a volatile storage medium and/or a non-volatile storage medium, for example, as a read only memory (ROM) and/or a random access memory (RAM).

Further, the memory 510 may store pieces of data such as battery capacity, threshold values, state of charge (SOC), and open circuit voltage (OCV), which are required during a process of detecting battery cell replacement by the processor 520. The data stored in the memory 510 may be predefined based on the specifications of a battery system and experimental results of the designer.

The processor 520, which is the primary component for detecting battery cell replacement, may be implemented as a central processing unit (CPU) or system on chip (SoC), and may run an operating system or applications to control a plurality of hardware or software components connected to the processor 520 and perform various data processing and computations. The processor 520 may be configured to execute at least one command stored in the memory 510 and store data resulting from the execution in the memory 510. The processor 520 may also be implemented as a BMS or a microcontroller unit (MCU) within the BMS, and may be configured to detect the current, voltage, OCV, and temperature of the battery cell. Such a sensing function of the BMS may support sensing operations for the parameters (e.g., SOC and OCV), which are considered during the detection of battery cell replacement.

Some embodiments focus on a configuration that detects an excess in an expected charging capacity to confirm that a battery cell has been replaced.

The processor 520 may obtain cell data related to the charging of the battery from the BMS and compare the cell data with data stored in the memory 510 to determine whether the battery cell has been replaced.

For example, the processor 520 may calculate an expected charging capacity for fully charging the battery after the battery wakes up. To this end, the processor 520 may calculate the expected charging capacity for fully charging the battery based on a current SOC value after the wake-up of the battery and battery capacity stored in the memory 510.

The processor 520 may determine whether the battery cell has been replaced by comparing an actual charging amount from the wake-up to full charge of the battery with the expected charging capacity for fully charging the battery.

That is, the processor 520 may determine that the battery cell has been replaced when a difference between the actual charging amount from the wake-up to full charge of the battery and the expected charging capacity for fully charging the battery exceeds a preset threshold value.

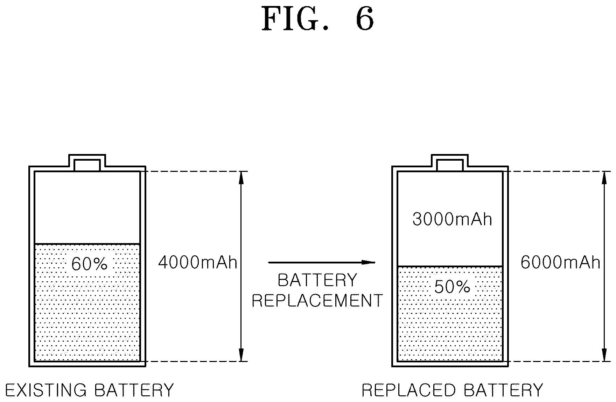

In this regard, FIG. 6 may be referenced as an example in the following description. For reference, FIG. 6 is a view for describing a process of detecting an excess in the expected charging capacity in the battery cell replacement detection apparatus according to some embodiments of the present disclosure.

As shown in FIG. 6, the processor 520 of Fig. 5 may calculate an expected charging capacity (e.g., 2,000 mAh) for fully charging the battery after wake-up, based on an SOC value (e.g., 50%) and an existing battery capacity (e.g., 4,000 mAh) recognized by the BMS.

When a replaced battery is fully charged, the processor 520 may calculate a charging capacity of the battery. At this time, because the capacity of the replaced battery is 6,000 mAh, in some examples, the processor 520 may calculate the expected charging capacity as, for example, 3,000 mAh by subtracting the SOC value (50%), which corresponds to 3,000 mAh, from 6,000 mAh.

Thus, 3,000 mAh will be charged, which exceeds a threshold value (2,000 mAh + set value α), thereby allowing the processor 520 to determine that the battery cell has been replaced.

For reference, the processor 520 may compensate the threshold value by comparing a voltage of a charger at a full charge point with the previous value. For example, when the charger is changed and the charging voltage is increased further, the processor 520 may increase the charging capacity of the battery in proportion to the increase in charging voltage.

When it is determined that the battery cell has been replaced, the processor 520 may enter a permanent fault mode to permanently prevent the battery from being used.

As a result, according to some embodiments of the present disclosure, when a battery cell in a battery pack is replaced with an abnormal battery cell that does not match the specifications of the battery pack, this can be detected, and a battery can be permanently prevented from being used, thereby preventing safety issues from arising with the battery and further encouraging the use of a standard battery pack instead.

As an example of arising safety issues, there are examples in which the replaced cell may be of lower quality and unable to support more than 10 A while the over-current protection of the BMS is set at 15 A.

Some embodiments focus on a configuration that detects SOC overflow during charging to confirm that a battery cell has been replaced.

The processor 520 may obtain cell data related to the charging of the battery from the BMS and compare the cell data with data stored in the memory 510 to determine whether the battery cell has been replaced.

For example, the processor 520 may determine whether the battery cell has been replaced by detecting an overflow in an SOC value during battery charging. To this end, the processor 520 may compare the SOC value from wake-up to first full charge of the battery with a threshold value stored in the memory 510.

The processor 520 may determine whether the battery cell has been replaced based on the comparison result between the SOC value of the battery and the threshold value stored in the memory 510. That is, the processor 520 may determine that the battery cell has been replaced when the SOC value of the battery is greater than or equal to the threshold value stored in the memory 510. Of course, the processor 520 may determine that the battery cell has not been replaced when the SOC value of the battery is less than the threshold value stored in the memory 510.

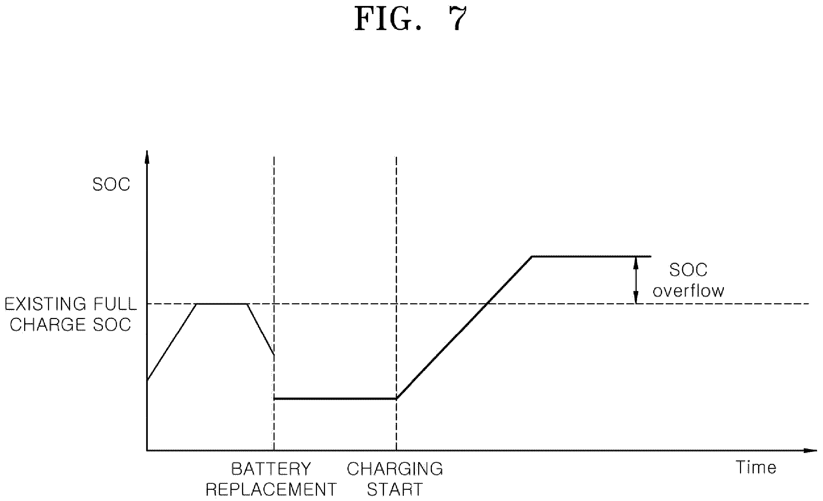

In this regard, FIG. 7 may be referenced as an example in the following description. For reference, FIG. 7 is a diagram for describing a process of detecting an SOC overflow during charging in the battery cell replacement detection apparatus according to some embodiments of the present disclosure.

As shown in FIG. 7, due to an increase in battery capacity during first full charge after wake-up, a greater amount of current is charged to the battery compared to before the replacement. In such a case, the BMS calculates the SOC based on the previously known battery capacity and accumulated current, during which an SOC overflow occurs due to the increased capacity from the cell replacement.

That is, in the case of the replaced battery, the SOC will increase by the amount of the increased capacity due to the cell replacement, and when an SOC overflow occurs, in which the increased SOC value exceeds a full charge SOC value (threshold value) of the existing battery, the processor 520 may determine that the battery cell has been replaced.

For reference, the processor 520 may compensate the threshold value by comparing a voltage of a charger at a full charge point with the previous value. For example, when the charger is changed and the charging voltage is increased further, the processor 520 may increase the charging capacity of the battery in proportion to the increase in charging voltage.

When it is determined that the battery cell has been replaced, the processor 520 may enter a permanent fault mode to permanently prevent the battery from being used.

As a result, according to some embodiments of the present disclosure, when a battery cell in a battery pack is replaced with an abnormal battery cell that does not match the specifications of the battery pack, this can be detected, and a battery can be permanently prevented from being used, thereby preventing safety issues from arising with the battery and further encouraging the use of a standard battery pack instead.

Some embodiments focus on a configuration that confirms the replacement of a battery cell by comparing OCV values at a full charge SOC.

The processor 520 may obtain cell data related to the charging of the battery from the BMS and compare the cell data with data stored in the memory 510 to determine whether the battery cell has been replaced.

For example, the processor 520 may determine whether the battery cell has been replaced by comparing an OCV value of the battery at the full charge SOC value with an OCV value stored in the memory 510. To this end, the processor 520 may stop charging at the point that is at a set range of the full charge SOC value (i.e., SOC ± α (a set value)), may measure an OCV value of the battery, and may compare the measured OCV value with the OCV value stored in the memory 510.

The processor 520 may determine that the battery cell has been replaced when a difference between the measured OCV value and the OCV value stored in the memory 510 exceeds a preset threshold value. Of course, when the difference between the measured OCV value and the OCV value stored in the memory 510 is less than or equal to the preset threshold value, the processor 520 may determine that the battery cell has not been replaced.

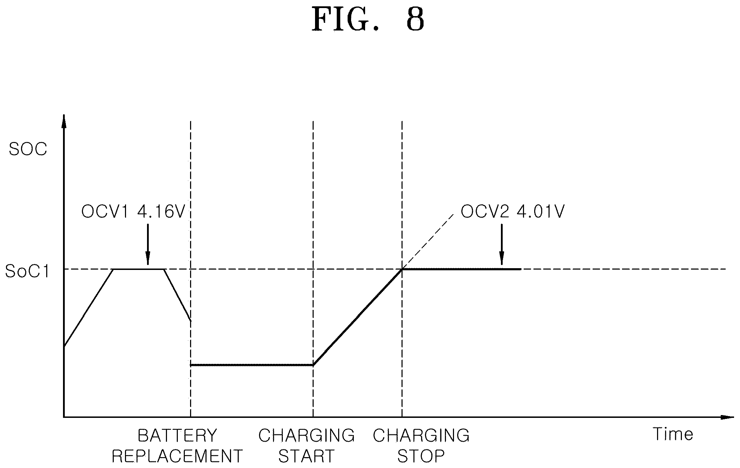

In this regard, FIG. 8 may be referenced as an example in the following description. For reference, FIG. 8 is a diagram for describing a process of comparing OCV values at a full charge SOC in the battery cell replacement detection apparatus according to some embodiments of the present disclosure.

As shown in FIG. 8, each time the battery is fully charged, the BMS may measure an SOC value (e.g., first SOC) and an OCV value (e.g., first OCV) after a set or predetermined period of time and store these values in the memory 510. The processor 520 may stop charging and measure an OCV value (second OCV) of the battery when an SOC value (second SOC) during charging after the battery wakes up falls within the range (e.g., first SOC ± α) of the SOC value (e.g., first SOC) stored in the memory 510.

The processor 520 may compare the OCV value (e.g., first OCV) stored in the memory 510 with the measured OCV value (e.g., second OCV). When the comparison results show that the difference exceeds a set or preset threshold value, the processor 520 may determine that the battery cell has been replaced.

When it is determined that the battery cell has been replaced, the processor 520 may enter a permanent fault mode to permanently prevent the battery from being used.

As a result, according to some embodiments of the present disclosure, when a battery cell in a battery pack is replaced with an abnormal battery cell that does not match the specifications of the battery pack, this can be detected, and a battery can be permanently prevented from being used, thereby preventing safety issues from arising with the battery and further encouraging the use of a standard battery pack instead.

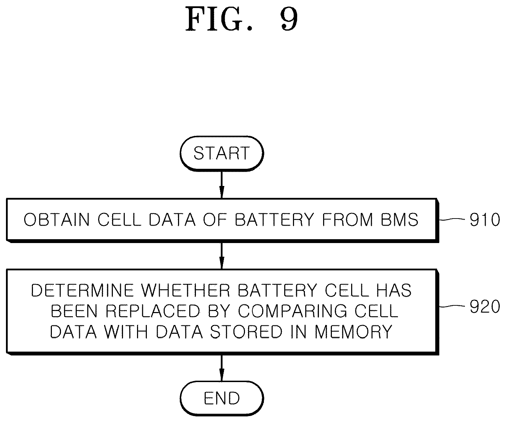

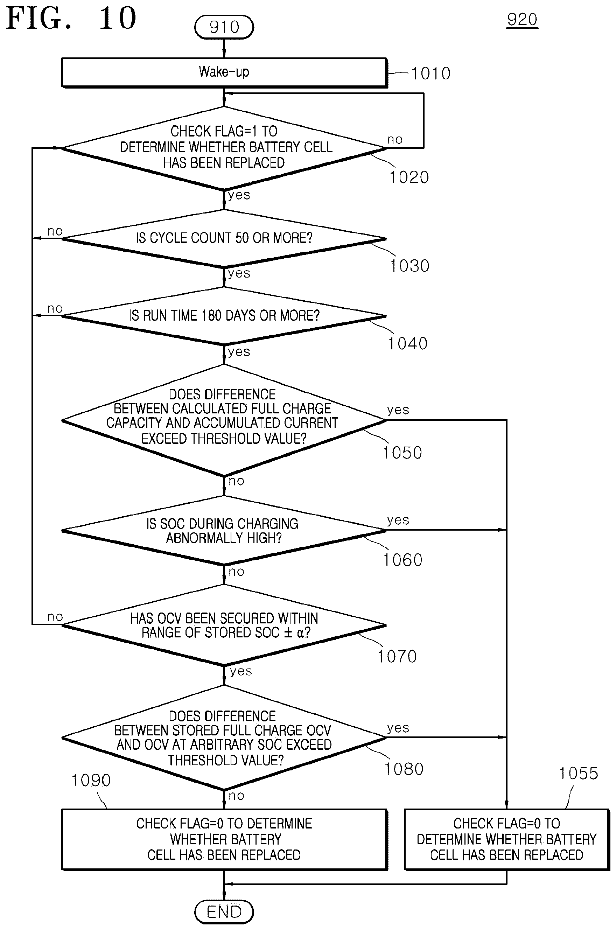

FIGS. 9 and 10 are flowcharts of a battery cell replacement detection method according to some embodiments of the present disclosure. The battery cell replacement detection method according to some embodiments of the present disclosure will be described with reference to FIGS. 9 and 10, and for the configurations that overlap with those described above, the detailed description may not be repeated and the description will focus on a chronological arrangement.

First, referring to FIGS. 1 and 9, in operation 910, the processor 520 obtains cell data related to the charging of the battery from the BMS.

Next, in operation 920, the processor 520 determines whether the battery cell has been replaced by comparing the cell data with data stored in the memory 510.

In this regard, a detailed description will be provided below with reference to FIG. 10.

First, after waking up the battery (1010), the processor 520 may confirm whether the battery cell has been replaced (1020). At this point, when a corresponding flag has a value of 1 (i.e., a "yes" direction of 1020), the processor 520 may check whether a cycle count is greater than or equal to 50 (1030), and when the cycle count is greater than or equal to 50 (the "yes" direction of 1030), the processor 520 may check whether a run time is 180 days or more (1040).

At this point, when the run time is 180 days or more (i.e., the "yes" direction of 1040), the processor 520 may check whether a difference between a calculated full charge capacity and an accumulated current value exceeds a threshold value (1050), and when the difference does not exceed the threshold value (i.e., a "no" direction of 1050), the processor 520 may check whether an SOC during charging is abnormally high (1060). When the SOC during charging is not abnormally high (i.e., the "no" direction of 1060), the processor 520 may check whether the OCV has been secured within the range of a stored SOC (i.e., SOC ± α) (1070), and when the OCV has been secured (the "yes" direction of 1070), the processor 520 may determine whether a difference between a stored full charge OCV and an OCV at an arbitrary SOC exceeds a threshold value (1080).

When the difference in OCV does not exceed the threshold value (i.e., the "no" direction of 1080), the processor 520 may set a cell replacement confirmation flag to 0. On the other hand, when the difference in OCV exceeds the threshold value (i.e., the "yes" direction of 1080), the processor 520 may enter a permanent fault mode to permanently prevent the battery from being used. The processor 520 may also enter the permanent fault mode in the case in which the difference in OCV exceeds the threshold value (i.e., the "yes" direction of 1050) or when the SOC during charging is abnormally high (i.e., the "yes" direction of 1060).

When the corresponding flag has a value other than 1 (the "no" direction of 1020), when the cycle count is less than 50 (i.e., the "no" direction of 1030), when the run time is less than 180 days (the "no" direction of 1040), or when the OCV has not been secured (i.e., the "no" direction of 1070), the processor 520 may return to the operation of confirming whether the battery cell has been replaced (1020).

As described above, according to some embodiments of the present disclosure, it is possible to permanently prevent a battery pack from being used by determining, through cell data retained by a BMS after the battery pack wakes up, that a battery cell has been replaced. Further, according to some embodiments of the present disclosure, when the battery cell in the battery pack is replaced with an abnormal battery cell that does not match the specifications of the battery pack, this can be detected, and a battery can be permanently prevented from being used, thereby preventing safety issues from arising with the battery and further encouraging the use of a standard battery pack instead.

The embodiments described herein may be implemented, for example, as a method or process, a device, a software program, a data stream, or a signal. Although discussed in the context of a single type of implementation (e.g., discussed only as a method), features discussed herein may also be implemented in other forms (e.g., a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

According to some embodiments of the present disclosure, it is possible to permanently prevent a battery pack from being used by determining, through cell data retained by a BMS after the battery pack wakes up, that a battery cell has been replaced.

Further, according to some embodiments of the present disclosure, when a battery cell in a battery pack is replaced with an abnormal battery cell that does not match the specifications of the battery pack, this can be detected, and a battery can be permanently prevented from being used, thereby preventing safety issues from arising with the battery and further encouraging the use of a standard battery pack instead.

However, effects that can be achieved through the present disclosure are not limited to the above-described effects and other effects that are not described may be clearly understood by those skilled in the art from the detailed descriptions.

Although the present disclosure has been described with reference to embodiments and drawings illustrating aspects thereof, the present disclosure is not limited thereto. Various suitable modifications and variations can be made by a person skilled in the art to which the present disclosure belongs within the scope of the technical present disclosure as defined by the claims and their equivalents, below.

## Claims

1. A battery cell replacement detection apparatus comprising:
a memory (510); and
a processor (520) configured to obtain cell data related to charging of a battery (M) from a battery management system (30), to compare the cell data with data stored in the memory (510), and to determine whether a battery cell (10a, 10b; C) has been replaced.

2. The battery cell replacement detection apparatus of claim 1, wherein the processor (520) is configured to enter a permanent fault mode to permanently prevent the battery (M) from being used in response to determining that the battery cell (10a, 10b; C) has been replaced.

3. The battery cell replacement detection apparatus of claim 1 or 2, wherein the processor (520) is configured to calculate an expected charging capacity for fully charging the battery (M) after wake-up.

4. The battery cell replacement detection apparatus of claim 3, wherein the processor (520) is configured to determine whether the battery cell (10a, 10b; C) has been replaced by comparing an actual charging amount from wake-up to full charge of the battery (M) with the expected charging capacity.

5. The battery cell replacement detection apparatus of claim 3 or **4,** wherein the processor (520) is configured to calculate the expected charging capacity based on a current state of charge, SOC, value after the battery (M) wakes up and a battery capacity stored in the memory (510).

6. The battery cell replacement detection apparatus of claim 4 or 5, wherein the processor (520) is configured to determine that the battery cell (10a, 10b; C) has been replaced in response to a difference between the actual charging amount and the expected charging capacity exceeding a preset threshold value.

7. The battery cell replacement detection apparatus of any one of claims 1 to 6, wherein the processor (520) is configured to determine whether the battery cell (10a, 10b; C) has been replaced by detecting an overflow in an SOC value during the charging of the battery (M).

8. The battery cell replacement detection apparatus of claim 7, wherein the processor (520) is configured to determine that the battery cell (10a, 10b; C) has been replaced in response to the SOC value of the battery (M) from wake-up to first full charge of the battery (M) exceeding a threshold value stored in the memory (510).

9. The battery cell replacement detection apparatus of any one of claims 1 to 8, wherein the processor (520) is configured to determine whether the battery cell (10a, 10b; C) has been replaced by comparing an open circuit voltage, OCV, value of the battery (M) at a full charge SOC value with an OCV value stored in the memory (510).

10. The battery cell replacement detection apparatus of claim 9, wherein the processor (520) is configured to stop the charging at a point that is a set range of the full charge SOC value of the battery (M), to measure the OCV value of the battery (M), and to compare the measured OCV value with the OCV value stored in the memory (510).

11. The battery cell replacement detection apparatus of claim 10, wherein the processor (520) is configured to determine that the battery cell (10a, 10b; C) has been replaced in response to a difference between the measured OCV value and the OCV value stored in the memory (510) exceeding a preset threshold value.

12. A battery cell replacement detection method comprising:
obtaining, by a processor (520), cell data related to charging of a battery (M) from a battery management system (30); and
determining, by the processor (520), whether a battery cell has been replaced by comparing the cell data with data stored in a memory (510).

13. The battery cell replacement detection method of claim 12, further comprising:
causing the processor (520) to enter a permanent fault mode to permanently prevent the battery (M) from being used in response to determining that the battery cell (10a, 10b; C) has been replaced.

14. The battery cell replacement detection method of claim 12 or 13, wherein the determining of whether the battery cell (10a, 10b; C) has been replaced comprises calculating an expected charging capacity for fully charging the battery (M) after wake-up.

15. The battery cell replacement detection method of claim 14, wherein the determining of whether the battery cell (10a, 10b; C) has been replaced further comprises:
comparing an actual charging amount from wake-up to full charge of the battery (M) with the expected charging capacity to determine whether the battery cell (10a, 10b; C) has been replaced.
